# EUROPEAN PATENT APPLICATION

(11) **EP 3 706 280 A1**
(43) Date of publication of application: **09.09.2020**
(21) Application number: 18872720.0
(22) Date of filing: 26.10.2018
(51) Int. Cl.: H02J 7/00

(54) **METHOD AND APPARATUS FOR TESTING CHARGING AND DISCHARGING OF LITHIUM BATTERY**

(30) Priority: 30.10.2017 CN 201711036715
(71) Applicant: NIO Nextev Limited, Central, Hong Kong (HK)
(72) Inventor: ZHAO, Jincheng, Jiading Shanghai 201804 (CN)
(74) Representative: Vossius & Partner Patentanwälte Rechtsanwälte mbB
(86) International application number: PCT/CN2018/112105
(87) International publication number: WO 2019/085833

(57) **Abstract**

The invention relates to the technical field of charging and discharging of batteries, and in particular to a method and apparatus for testing the charging and discharging of a lithium battery. The method comprises: within the same time period, enabling at least one battery pack to be charged and discharged to acquire electric energy from a power grid, and performing a battery pack charging action; and enabling at least one battery pack to be charged and discharged to transmit electric energy to the power grid, and performing a battery pack discharging action. The invention avoids the demand for a large amount of electric energy and the demand for a large power distribution capacity of a power grid when a charging test is independently performed on a lithium battery, and a power transmission and distribution device required to satisfy a power distribution capacity can be omitted; the demand for a large-load device when a lithium battery is independently discharged is avoided; and the charging cost can be reduced dramatically, thus having great economic benefits.

## Description

### Technical Field

The invention relates to the technical field of charging and discharging of batteries, and in particular to a method and apparatus for testing the charging and discharging of a lithium battery.

### Background Art

At present, electric vehicles are developed rapidly, and the performance of a lithium battery, which is used as a power source of the electric vehicle, directly affects the cruising range of the electric vehicle, and then affects the user experience, which makes it very important to know detailed performance parameters of the lithium battery. For this reason, a large number of charging and discharging tests need to be performed on the lithium battery. At the same time, due to the massive development of the electric vehicles, gradient utilization of retired batteries of the electric vehicles is also proposed rapidly, which also requires knowledge of performance parameters of the retired batteries. In the absence of detailed data usage records, the most direct way is to implement charging and discharging tests of several cycles.

Charging and discharging experiments are performed simultaneously on a large number of lithium batteries, which requires a relatively large charging and discharging power, thereby imposing more severe requirements for a power grid and power distribution in a laboratory; moreover, a large amount of electric energy needs to be consumed during charging, and a large load is required during discharging, which will cause huge economic investment.

In view of defects of the existing large number of lithium batteries described above, the inventors have actively made a research and innovation based on many years of rich and practical experience and professional knowledge in the design and manufacture of such products, in order to create a new type of method and apparatus for testing the charging and discharging of a lithium battery, so that the method and apparatus are more practical. After continuous research and design, and repeated trial production of and improvements on samples, the invention with practical value was finally created.

### Summary of the Invention

An object of the invention is to provide a method and apparatus for testing the charging and discharging of a lithium battery, so as to reduce requirements for a power grid and power distribution, and reduce the economic investment in battery charging and discharging processes.

The object of the invention is realized by virtue of the following technical solution.

The invention provides a method for testing the charging and discharging of a lithium battery, the method comprising: within the same time period, enabling at least one battery pack to be charged and discharged to acquire electric energy from a power grid, and performing a battery pack charging action; and enabling at least one battery pack to be charged and discharged to transmit electric energy to the power grid, and performing a battery pack discharging action, so as to test the charging and discharging of a battery.

The method specifically comprises:
converting alternating current of the power grid into direct current to perform a charging action and converting direct current of the battery pack to be charged and discharged into alternating current to perform a discharging action by means of a power conversion module.

The method further comprises acquiring, in real time, operation information of the power conversion module and charging and discharging operation information of the battery pack to be charged and discharged.

The method further comprises acquiring, according to the charging and discharging operation information of the battery pack to be charged and discharged, charging and discharging warning information of the battery pack to be charged and discharged.

The method further comprises displaying the operation information of the power conversion module, the charging and discharging operation information of the battery pack to be charged and discharged, and the charging and discharging warning information of the battery pack to be charged and discharged.

The method further comprises: within the same time period, enabling the battery pack to be charged and discharged to acquire electric energy from the power grid, and performing a battery energy storage action, or enabling the battery pack to be charged and discharged to transmit electric energy to the power grid, and performing a power grid energy storage action.

The method specifically comprises: performing, by means of a power conversion module, battery pack charging and discharging actions, and converting alternating current of the power grid into direct current to store energy for the battery pack when the power grid has an adequate capacity; and converting direct current of the battery pack into alternating current to store energy for the power grid when the power grid has an inadequate capacity.

The method further comprises acquiring, in real time, operation information of the power conversion module and charging and discharging operation information of the battery pack to be charged and discharged.

The method further comprises acquiring, according to the charging and discharging operation information of the battery pack to be charged and discharged, charging and discharging warning information of the battery pack to be charged and discharged.

The method further comprises displaying the operation information of the power conversion module, the charging and discharging operation information of the battery pack to be charged and discharged, and the charging and discharging warning information of the battery pack to be charged and discharged.

The invention also provides an apparatus for testing the charging and discharging of a lithium battery, the apparatus comprising: a main control unit and at least two battery charging and discharging module groups, wherein the battery charging and discharging module groups are connected to a power grid, such that under the control of the main control unit and within the same time period, at least one of the battery charging and discharging module groups acquires electric energy from the power grid and performs a battery charging action, and at least one of the battery charging and discharging module groups transmits electric energy to the power grid and performs a battery discharging action, so as to test the charging and discharging of a battery.

Further, the battery charging and discharging module group comprises a power conversion module, a charging and discharging control module and a battery pack;
the charging and discharging control module is connected to the power conversion module and the battery pack, and is configured to receive an instruction from the control unit to control the power conversion module to perform charging and discharging actions on the battery pack; and
the power conversion module is connected to the power grid and the battery pack, and is configured to convert alternating current of the power grid into direct current to perform a charging action and convert direct current of the battery pack into alternating current to perform a discharging action.

Further, the charging and discharging control module is further configured to acquire, in real time, operation information of the power conversion module and charging and discharging operation information of the battery pack.

Further, the charging and discharging control module is further configured to acquire charging and discharging warning information of the battery pack according to the charging and discharging operation information.

Further, the control unit comprises a human-machine interface, and the human-machine interface is configured to input a control instruction and display the operation information of the power conversion module, the charging and discharging operation information of the battery pack, and the charging and discharging warning information of the battery pack.

Further, the battery charging and discharging module group is further configured to, under the control of the main control unit and within the same time period, acquire electric energy from the power grid and perform a battery energy storage action, or transmit electric energy to the power grid and perform a power grid energy storage action.

Further, the battery charging and discharging module group comprises a power conversion module, a charging and discharging control module and a battery pack; the charging and discharging control module is connected to the power conversion module and the battery pack, and the power conversion module is connected to the power grid and the battery pack;
the charging and discharging control module is configured to receive an instruction from the control unit to control the power conversion module to perform charging and discharging actions on the battery pack, and control the power conversion module to convert alternating current of the power grid into direct current to store energy for the battery pack when the power grid has an adequate capacity; and control the power conversion module to convert direct current of the battery pack into alternating current to store energy for the power grid when the power grid has an inadequate capacity.

Further, the charging and discharging control module is further configured to acquire, in real time, operation information of the power conversion module and charging and discharging operation information of the battery pack.

Further, the charging and discharging control module is further configured to acquire charging and discharging warning information of the battery pack according to the charging and discharging operation information.

Further, the control unit comprises a human-machine interface, and the human-machine interface is configured to input a control instruction and display the operation information of the power conversion module, the charging and discharging operation information of the battery pack, and the charging and discharging warning information of the battery pack.

The invention further comprises a controller, which comprises a memory and a processor, wherein the memory stores a computer program that, when executed by the processor, can implement the steps of the method described above.

The invention further comprises a computer-readable storage medium for storing computer instructions that, when executed by a computer or a processor, implement the steps of the method described above.

By means of the method and apparatus for testing the charging and discharging of a lithium battery, the invention avoids the demand for a large amount of electric energy and the demand for a large power distribution capacity of a power grid when a charging test is independently performed on a lithium battery, and a power transmission and distribution device required to satisfy a power distribution capacity can be omitted; the demand for a large-load device when a lithium battery is independently discharged is avoided; and the charging cost can be reduced dramatically, thus having great economic benefits.

The description above is only summary of the technical solution of the invention. In order to understand the technical means of the invention more clearly for implementation according to the contents of the specification, and in order to make the above and other objectives, features and advantages of the invention more apparent and easy to be understood, preferred embodiments are especially taken as examples in conjunction with the accompanying drawings, and the detailed description is as follows.

### Brief Description of the Drawings

FIG. 1 is a schematic diagram of composition of a preferred embodiment of an apparatus for testing the charging and discharging of a lithium battery according to the invention;
FIG. 2 is a schematic diagram of operating of the apparatus for testing the charging and discharging of a lithium battery in a cyclic battery charging and discharging mode according to the invention; and
FIGs. 3a and 3b are schematic diagrams of operating of the apparatus for testing the charging and discharging of a lithium battery in an energy storage mode according to the invention.

### Detailed Description of Embodiments

The invention is further described in detail below by means of particular embodiments and in conjunction with the accompanying drawings.

This embodiment provides a method for testing the charging and discharging of a lithium battery, the method comprising: within the same time period, enabling at least one battery pack to be charged and discharged to acquire electric energy from a power grid, and performing a battery pack charging action; and enabling at least one battery pack to be charged and discharged to transmit electric energy to the power grid, and performing a battery pack discharging action, so as to test the charging and discharging of a battery.

Assuming that 2N batteries require charging and discharging tests, N batteries operate in a charging mode, and the required maximum total power is Pchg, and the other N batteries are in a discharging mode, and the discharged maximum total power is Pdischg, and the power that needs to be provided by the power grid when the 2N batteries are tested at the same time is (Pchg-Pdischg), which greatly reduces, compared with 2Pchg or 2Pdischg provided for separate discharging or charging of the 2N batteries, the required electric power capacity distributed by the power grid and the power device costs required to support these power capacities, and achieves a significant reduction of energy consumption.

In this embodiment, by dividing the batteries (battery packs) to be charged and discharged into two groups (at least one battery pack to be charged and discharged per group), one group is in a charging process and the other group is in a discharging process, and the two groups of battery packs are controlled to operate at the same time, so that the two groups of battery packs are in a charging and discharging hedge state, which solves not only the problem that a large amount of electric energy needs to be acquired from the power grid for battery charging, but also the problem that an extra large load is required for battery discharging, thereby reducing charging energy costs during battery charging and discharging and large load purchase costs during discharging. At the same time, the two groups of battery packs are mounted close to the power grid, as only as a wire with an adequate current-carrying capacity needs to be equipped, so as to avoid the application for excessive power distribution capacity from the power grid and a power transmission and distribution device required for supporting the excessive power distribution capacity.

The method specifically comprises:
converting alternating current of the power grid into direct current to perform a charging action and converting direct current of the battery pack to be charged and discharged into alternating current to perform a discharging action, by means of a bidirectional AC/DC power conversion module. Compared with a hedge platform directly based on a DC/DC conversion manner, this method does not impose the following requirements on batteries to be tested: initial states of charge are equal, and the batteries to be tested must be in a one-to-one correspondence.

The method further comprises acquiring, in real time, operation information of the power conversion module and charging and discharging operation information of the battery pack to be charged and discharged, so as to realize the monitoring of the power conversion module.

The method further comprises acquiring, according to the charging and discharging operation information of the battery pack to be charged and discharged, charging and discharging warning information of the battery pack to be charged and discharged, so as to provide real-time charging and discharging warning protection.

The method further comprises displaying the operation information of the power conversion module, the charging and discharging operation information of the battery pack to be charged and discharged, and the charging and discharging warning information of the battery pack to be charged and discharged, so as to realize the monitoring throughout the battery charging and discharging process.

In the absence of a battery charging and discharging cycle test, within the same time period, the battery pack to be charged and discharged acquires electric energy from the power grid, and performs a battery energy storage action, or the battery pack to be charged and discharged transmits electric energy to the power grid, and performs a power grid energy storage action, so as to realize the function of energy storage at idle.

The function of energy storage at idle may be realized by performing battery pack charging and discharging actions by means of a bidirectional AC/DC power conversion module, and alternating current of the power grid is converted into direct current to store energy for the battery pack when the power grid has an adequate capacity; and direct current of the battery pack is converted into alternating current to store energy for the power grid when the power grid has an inadequate capacity.

When energy is stored at idle, like the testing of the charging and discharging of a battery, the method further comprises: acquiring, in real time, operation information of the power conversion module and charging and discharging operation information of the battery pack to be charged and discharged; acquiring, according to the charging and discharging operation information of the battery pack to be charged and discharged, charging and discharging warning information of the battery pack to be charged and discharged; and displaying the operation information of the power conversion module, the charging and discharging operation information of the battery pack to be charged and discharged, and the charging and discharging warning information of the battery pack to be charged and discharged.

It should be noted that, by means of the method for testing the charging and discharging of a battery, a charging and discharging cycle test for a lithium battery, deep charging and discharging of a lithium battery, and the testing of various functions of a single lithium battery (pack) may also be realized.

The invention further comprises a controller, which comprises a memory and a processor, wherein the memory stores a computer program that, when executed by the processor, can implement the steps of the method described above.

The invention further comprises a computer-readable storage medium for storing computer instructions that, when executed by a computer or a processor, implement the steps of the method described above.

This embodiment also provides an apparatus for testing the charging and discharging of a lithium battery, the apparatus comprising: a main control unit and at least two battery charging and discharging module groups, wherein the battery charging and discharging module groups are connected to a power grid, such that under the control of the main control unit and within the same time period, at least one of the battery charging and discharging module groups acquires electric energy from the power grid and performs a battery charging action, and at least one of the battery charging and discharging module groups transmits electric energy to the power grid and performs a battery discharging action, so as to test the charging and discharging of a battery.

The apparatus voids the demand for a large amount of electric energy and the demand for a large power distribution capacity of a power grid when a charging test is independently performed on a lithium battery, and a power transmission and distribution device required to satisfy a power distribution capacity can be omitted; the demand for a large-load device when a lithium battery is independently discharged is avoided; and the charging cost can be reduced dramatically, thus having great economic benefits.

Further, the battery charging and discharging module group comprises a power conversion module, a charging and discharging control module and a battery pack; the charging and discharging control module is connected to the power conversion module and the battery pack, and is configured to receive an instruction from the control unit to control the power conversion module to perform charging and discharging actions on the battery pack; and the power conversion module is connected to the power grid and the battery pack, and is configured to convert alternating current of the power grid into direct current to perform a charging action and convert direct current of the battery pack into alternating current to perform a discharging action. Bidirectional (AC/DC) flow of energy is realized by means of the power conversion module, and compared with a hedge platform directly based on a DC/DC conversion manner, this method does not impose the following requirements on batteries to be tested: initial states of charge are equal, and the batteries to be tested must be in a one-to-one correspondence.

Further, the charging and discharging control module is further configured to acquire, in real time, operation information of the power conversion module and charging and discharging operation information of the battery pack, so as to realize the monitoring of the power conversion module.

Further, the charging and discharging control module is further configured to acquire charging and discharging warning information of the battery pack according to the charging and discharging operation information, so as to provide real-time charging and discharging warning protection.

Further, the control unit comprises a human-machine interface, and the human-machine interface is configured to input a control instruction and display the operation information of the power conversion module, the charging and discharging operation information of the battery pack, and the charging and discharging warning information of the battery pack, so as to realize the monitoring throughout the battery charging and discharging process.

In the absence of a battery charging and discharging cycle test, the battery charging and discharging module group is further configured to, under the control of the main control unit and within the same time period, acquire electric energy from the power grid and perform a battery energy storage action, or transmit electric energy to the power grid and perform a power grid energy storage action, so as to realize the function of energy storage at idle.

Specifically, when the apparatus needs to store energy at idle, the charging and discharging control module is configured to receive an instruction from the control unit to control the power conversion module to perform charging and discharging actions on the battery pack, and control the power conversion module to convert alternating current of the power grid into direct current to store energy for the battery pack when the power grid has an adequate capacity; and control the power conversion module to convert direct current of the battery pack into alternating current to store energy for the power grid when the power grid has an inadequate capacity.

When energy is stored at idle, like the testing of the charging and discharging of a battery, the charging and discharging control module is further configured to acquire, in real time, operation information of the power conversion module and charging and discharging operation information of the battery pack; the charging and discharging control module is further configured to acquire charging and discharging warning information of the battery pack according to the charging and discharging operation information; and the control unit comprises a human-machine interface, and the human-machine interface is configured to input a control instruction and display the operation information of the power conversion module, the charging and discharging operation information of the battery pack, and the charging and discharging warning information of the battery pack.

It should be noted that, by means of the apparatus described above, a charging and discharging cycle test for a lithium battery, deep charging and discharging of a lithium battery, and the testing of various functions of a single lithium battery (pack) may also be realized.

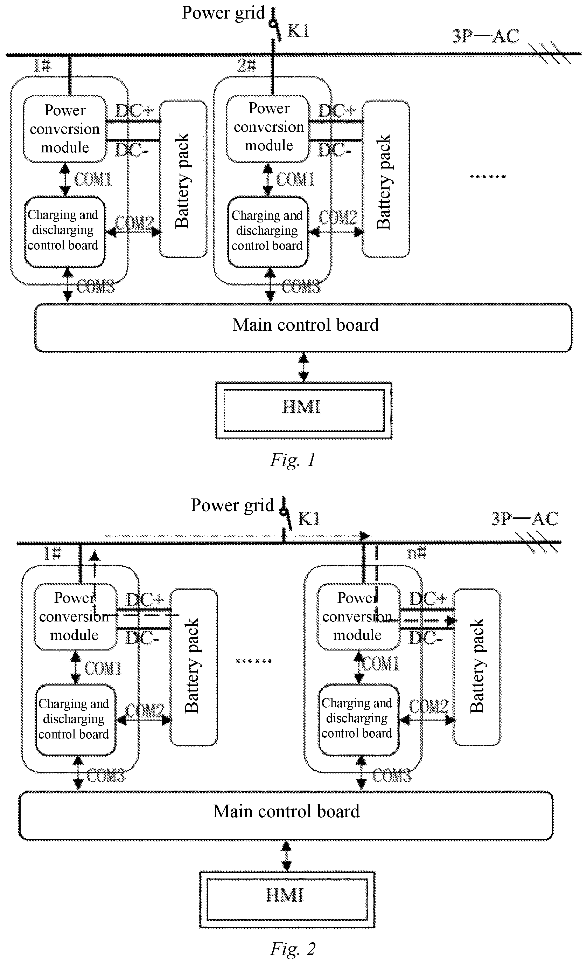

As shown in FIG. 1, FIG. 1 shows a preferred embodiment of the invention. In this embodiment, a charging and discharging hedge platform for a lithium battery is built. The entire platform comprises several independent battery charging and discharging module groups (1#, 2#, ..., n#) and a main control board, and each of the battery charging and discharging module groups comprises a bidirectional AC/DC power conversion module, a charging and discharging control board and a battery pack to be charged and discharged; each module group controls, by means of the charging and discharging control board, input and output currents at the direct current side of the power conversion module through communication, and then controls actual charging and discharging currents of the battery, and also acquires real-time operation information of the corresponding bidirectional AC/DC power module through communication.

Each charging and discharging control board communicates with a battery management system (BMS) of a battery pack to acquire real-time information status of the battery pack and provide real-time charging and discharging warning protection.

All the charging and discharging control boards communicate with the main control board, are uniformly coordinated and controlled by the main control board, perform upward-sending to the main control board, and then perform displaying on a human-machine interface (HMI).

At the same time, during the whole process, the platform will record charging and discharging operation information of each battery in real time, and save the information into a file in a specific format for later analysis.

In this platform, the power conversion module is a bidirectional AC/DC power module, which can realize the bidirectional flow of energy; the charging and discharging control board can use a DSP, an ARM or other SCM chips; and the main control board may be realized in a manner of ARM + HMI, or by an industrial personal computer.

All the components communicate with each other via a CAN.

When a battery pack needs to be tested, the battery pack to be tested is connected to the system, and then operating modes are set on the HMI of the main control board of the platform. In all the operating modes, wiring is consistent, as only as the battery pack is connected to DC+ and DC- of the power conversion module, a communication line and an auxiliary power source of the battery pack.

The basic operating mode of the entire platform is as follows:
1. Cyclic battery charging and discharging mode:
   in this mode, the operating steps are as follows:
   1) connecting the battery pack to be tested to the platform;
   2) setting the operating mode of the platform to the "cyclic battery charging and discharging mode" by means of the HMI;
   3) setting an operating state of each battery charging and discharging module group according to the testing needs, and such that the battery charging and discharging module group operates in a charging or discharging state;
   4) setting the required number of cycles, a rest time after completion of charging and discharging, and a protection parameter;
   5) setting the required charging and discharging current (which can be set to follow a charging current request of the battery pack BMS during charging);
   6) starting the platform such that the platform starts operating.

   As shown in FIG. 2, assuming that the m# battery charging and discharging module group is in a discharging mode, the n# battery charging and discharging module group is in a charging mode, and a flow direction of energy is the direction indicated by the arrow in the figure, the entire charging and discharging platform acquires little energy from the power grid where the charging and discharging currents are equal.
2. Full-automatic cyclic charging and discharging hedge mode:
   in this mode, the main control board automatically, based on a state of charge (SOC) of the battery packs to be tested, divides all battery packs into charging and discharging modes, and the specific operation steps are as follows:
   1) connecting the battery pack to be tested to the platform;
   2) setting the operating mode of the platform to the "full-automatic cyclic charging hedge mode" by means of the HMI;
   3) setting parameters such as the number of automatic cycles, a rest time after completion of charging and discharging, a charging and discharging voltage and current protection value, a temperature protection value;
   4) setting the required charging and discharging current (which can be set to follow a charging current request of the battery pack BMS during charging);
   5) starting the platform.

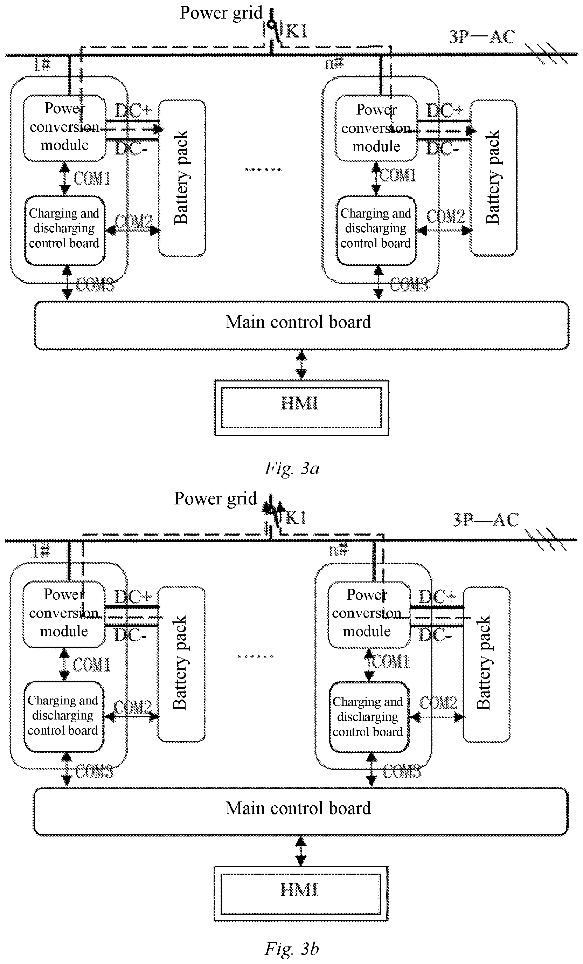

   In this way, the entire platform can start an automatic charging and discharging cycle to complete the required number of times of hedging.
3. Deep charging and discharging mode of a battery:
   the operations in this mode are similar to those in the cyclic battery charging and discharging mode, with the difference being that the required charging and discharging depth and charging and discharging current values need to be set.
4. Energy storage mode:
   in this mode, all battery charging and discharging module groups have the same operating state at the same time. FIG. 3a is a schematic diagram of an energy flow of battery pack charging energy storage; and FIG. 3b is a schematic diagram of an energy flow of discharging from a battery pack towards a power grid.
   When there is no battery charging and discharging task on the platform, the platform may switch to the energy storage mode. When the power grid has adequate energy, all battery charging and discharging module groups are set to the charging state, and the power conversion module operates in an AC-to-DC manner, so that excessive energy in the power grid is stored in the battery pack. During a power consumption peak, all battery charging and discharging module groups are set to the discharging mode, and the power conversion module operates in a DC-to-AC manner, so that the function of discharging from the battery pack to the power grid can be realized.
   The operation steps are as follows:
   1) calculating the required energy storage capacity;
   2) in conjunction with the actual maximum capacity of the battery pack, connecting the required number of battery packs;
   3) setting the platform to an energy storage mode;
   4) setting charging and discharging power (the main control board may communicate with a third party to acquire allowed charging and discharging power, and can be configured to operate according to power requirements of the third party; or a manual adjustment may be performed by means of the HMI);
   5) setting start and end time nodes for charging and discharging (which can be scheduled in real time through communication with the third party);
   6) starting the platform, such that the platform operates in the energy storage mode.
5. Single battery test mode:
   to test various charging and discharging performances and limit performance of a single battery, the wiring of the platform is the same as that in the various modes described above.

The charging and discharging hedge platform for a lithium battery built in the invention integrates various functions such as a charging and discharging cycle test for a lithium battery, deep charging and discharging of a lithium battery, the testing of various functions of a single lithium battery, and energy storage at idle, and has the following technical effects:
1) the demand for a large amount of electric energy and the demand for a large power distribution capacity of a power grid when a charging test is independently performed on a lithium battery are avoided, and at the same time, a power transmission and distribution device required to satisfy a power distribution capacity is also omitted;
2) the demand for a large-load device when a lithium battery is independently discharged is avoided;
3) costs of electric energy for charging can be reduced dramatically;
4) the operating mode of the platform can be set on the HMI of the main control board, which is easy to operate; and
5) the platform also has functions such as power grid energy storage and single battery testing.

The foregoing description is merely the preferred embodiments of the invention and is not intended to be limiting of the invention, and various changes and modifications may be made by a person skilled in the art. Any modifications, equivalent substitutions, improvements etc. made within the spirit and principles of the invention are intended to be included within the scope of protection of the invention.

## Claims

1. A method for testing the charging and discharging of a lithium battery, **characterized by** comprising: within the same time period, enabling at least one battery pack to be charged and discharged to acquire electric energy from a power grid, and performing a battery pack charging action; and enabling at least one battery pack to be charged and discharged to transmit electric energy to the power grid, and performing a battery pack discharging action, so as to test the charging and discharging of a battery.

2. The method for testing the charging and discharging of a lithium battery according to claim 1, **characterized in that** the method specifically comprises:
converting alternating current of the power grid into direct current to perform a charging action and converting direct current of the battery pack to be charged and discharged into alternating current to perform a discharging action by means of a power conversion module.

3. The method for testing the charging and discharging of a lithium battery according to claim 2, **characterized by** further comprising: acquiring, in real time, operation information of the power conversion module and charging and discharging operation information of the battery pack to be charged and discharged.

4. The method for testing the charging and discharging of a lithium battery according to claim 3, **characterized by** further comprising: acquiring, according to the charging and discharging operation information of the battery pack to be charged and discharged, charging and discharging warning information of the battery pack to be charged and discharged.

5. The method for testing the charging and discharging of a lithium battery according to claim 4, **characterized by** further comprising: displaying the operation information of the power conversion module, the charging and discharging operation information of the battery pack to be charged and discharged, and the charging and discharging warning information of the battery pack to be charged and discharged.

6. The method for testing the charging and discharging of a lithium battery according to claim 1, **characterized by** further comprising:
within the same time period, enabling the battery pack to be charged and discharged to acquire electric energy from the power grid, and performing a battery energy storage action, or enabling the battery pack to be charged and discharged to transmit electric energy to the power grid, and performing a power grid energy storage action.

7. The method for testing the charging and discharging of a lithium battery according to claim 6, **characterized in that** the method specifically comprises:
performing, by means of a power conversion module, battery pack charging and discharging actions, and converting alternating current of the power grid into direct current to store energy for the battery pack when the power grid has an adequate capacity; and converting direct current of the battery pack into alternating current to store energy for the power grid when the power grid has an inadequate capacity.

8. The method for testing the charging and discharging of a lithium battery according to claim 7, **characterized by** further comprising: acquiring, in real time, operation information of the power conversion module and charging and discharging operation information of the battery pack to be charged and discharged.

9. The method for testing the charging and discharging of a lithium battery according to claim 8, **characterized by** further comprising: acquiring, according to the charging and discharging operation information of the battery pack to be charged and discharged, charging and discharging warning information of the battery pack to be charged and discharged.

10. The method for testing the charging and discharging of a lithium battery according to claim 9, **characterized by** further comprising: displaying the operation information of the power conversion module, the charging and discharging operation information of the battery pack to be charged and discharged, and the charging and discharging warning information of the battery pack to be charged and discharged.

11. An apparatus for testing the charging and discharging of a lithium battery, **characterized by** comprising: a main control unit and at least two battery charging and discharging module groups, wherein the battery charging and discharging module groups are connected to a power grid, such that under the control of the main control unit and within the same time period, at least one of the battery charging and discharging module groups acquires electric energy from the power grid and performs a battery charging action, and at least one of the battery charging and discharging module groups transmits electric energy to the power grid and performs a battery discharging action, so as to test the charging and discharging of a battery.

12. The apparatus for testing the charging and discharging of a lithium battery according to claim 11, **characterized in that** the battery charging and discharging module group comprises a power conversion module, a charging and discharging control module and a battery pack;
the charging and discharging control module is connected to the power conversion module and the battery pack, and is configured to receive an instruction from the control unit to control the power conversion module to perform charging and discharging actions on the battery pack; and
the power conversion module is connected to the power grid and the battery pack, and is configured to convert alternating current of the power grid into direct current to perform a charging action and convert direct current of the battery pack into alternating current to perform a discharging action.

13. The apparatus for testing the charging and discharging of a lithium battery according to claim 12, **characterized in that** the charging and discharging control module is further configured to acquire, in real time, operation information of the power conversion module and charging and discharging operation information of the battery pack.

14. The apparatus for testing the charging and discharging of a lithium battery according to claim 13, **characterized in that** the charging and discharging control module is further configured to acquire charging and discharging warning information of the battery pack according to the charging and discharging operation information.

15. The apparatus for testing the charging and discharging of a lithium battery according to claim 14, **characterized in that** the control unit comprises a human-machine interface, and the human-machine interface is configured to input a control instruction and display the operation information of the power conversion module, the charging and discharging operation information of the battery pack, and the charging and discharging warning information of the battery pack.

16. The apparatus for testing the charging and discharging of a lithium battery according to claim 11, **characterized in that** the battery charging and discharging module group is further configured to, under the control of the main control unit and within the same time period, acquire electric energy from the power grid and perform a battery energy storage action, or transmit electric energy to the power grid and perform a power grid energy storage action.

17. The apparatus for testing the charging and discharging of a lithium battery according to claim 16, **characterized in that** the battery charging and discharging module group comprises a power conversion module, a charging and discharging control module and a battery pack; the charging and discharging control module is connected to the power conversion module and the battery pack, and the power conversion module is connected to the power grid and the battery pack;
the charging and discharging control module is configured to receive an instruction from the control unit to control the power conversion module to perform charging and discharging actions on the battery pack, and control the power conversion module to convert alternating current of the power grid into direct current to store energy for the battery pack when the power grid has an adequate capacity; and control the power conversion module to convert direct current of the battery pack into alternating current to store energy for the power grid when the power grid has an inadequate capacity.

18. The apparatus for testing the charging and discharging of a lithium battery according to claim 17, **characterized in that** the charging and discharging control module is further configured to acquire, in real time, operation information of the power conversion module and charging and discharging operation information of the battery pack.

19. The apparatus for testing the charging and discharging of a lithium battery according to claim 18, **characterized in that** the charging and discharging control module is further configured to acquire charging and discharging warning information of the battery pack according to the charging and discharging operation information.

20. The apparatus for testing the charging and discharging of a lithium battery according to claim 19, **characterized in that** the control unit comprises a human-machine interface, and the human-machine interface is configured to input a control instruction and display the operation information of the power conversion module, the charging and discharging operation information of the battery pack, and the charging and discharging warning information of the battery pack.

21. A controller, comprising a memory and a processor, wherein the memory stores a computer program that, when executed by the processor, can implement the steps of the method according to any of claims 1 to 10.

22. A computer-readable storage medium for storing computer instructions that, when executed by a computer or a processor, implement the steps of the method according to any of claims 1 to 10.
